Europäisches Patentamt

(19) European Patent Office

Office européen des brevets

(11) Numéro de publication: **0 265 314**
**A1**

# (12) DEMANDE DE BREVET EUROPEEN

(21) Numéro de dépôt: 87402214.8

(22) Date de dépôt: 06.10.87

(51) Int. Cl.⁴: **H 01 L 21/314**
H 01 L 29/62, H 01 L 29/40

(30) Priorité: 06.10.86 FR 8613883

(43) Date de publication de la demande:
27.04.88 Bulletin 88/17

(84) Etats contractants désignés: **DE GB**

(71) Demandeur: ETAT FRANCAIS représenté par le Ministre des PTT (Centre National d'Etudes des Télécommunications)
38-40 rue du Général Leclerc
F-92131 Issy-les-Moulineaux (FR)

CENTRE NATIONAL DE LA RECHERCHE SCIENTIFIQUE (CNRS)
15, Quai Anatole France
F-75007 Paris (FR)

(72) Inventeur: Dimitriou, Pierre
23 rue Girardot
F-93170 Bagnolet (FR)

Post, Georges
65 rue Racine
F-92120 Montrouge (FR)

Cot, Louis
Résidence Les Pins No. 3
F-34170 Clapiers-Castelnau Le Lez (FR)

Durand, Jean Les Hauts de l'Aruel - D
1147 Av. Villeneuve Angoulême
F-34100 Montpellier (FR)

Gendry, Michel
Le Larzat
F-34750 Villeneuve Les Magueionne (FR)

(74) Mandataire: Ahner, Francis et al
CABINET REGIMBEAU 26, avenue Kléber
F-75116 Paris (FR)

(54) procédé de formation d'une couche isolante comportant du sulfure, dérivés sulfures obtenus et appareillage pour la mise en oeuvre du procédé.

(57) La présente invention concerne un procédé de dépôt d'une couche isolante comportant du sulfure sur un substrat cristallin semiconducteur d'orientation particulière, en particulier en vue de créer une structure MIS, caractérisé en ce que l'on soumet ledit substrat cristallin semiconducteur à une décharge électroluminescente dans une atmosphère gazeuse contenant au moins un dérivé gazeux du soufre.

Elle concerne également les dérivés obtenus et l'appareillage nécessaire pour la mise en oeuvre du procédé.

EP 0 265 314 A1

## Description

<u>PROCEDE DE FORMATION D'UNE COUCHE ISOLANTE COMPORTANT DU SULFURE, DERIVES SULFURES OBTENUS ET APPAREILLAGE POUR LA MISE EN OEUVRE DU PROCEDE.</u>

La présente invention concerne la réalisation d'une nouvelle structure de type isolant-semiconducteur dans laquelle le semiconducteur est un composé du type $A^{III}B^{V}$ dans lequel A et B représentent deux éléments appartenant respectivement aux colonnes III et V de la classification périodique de Mendeleïev, et formant ensemble un semiconducteur, de préférence intermétallique tel que l'arséniure de gallium Ga As ou le phosphure d'indium In P, et III et V représentent la valence de l'élément correspondant.

Elle trouve diverses applications, notamment dans le domaine de la microélectronique où elle permet de réaliser des composants de type M.I.S. (Métal-Isolant-Semiconducteur) très performants ainsi que dans le domaine de la microoptoélectronique où elle permet de réaliser une passivation des faces de composants optoélectroniques.

Les semiconducteurs $A^{III}B^{V}$ présentent dans ces deux domaines un intérêt croissant par rapport au silicium classiquement utilisé, en particulier grâce à leurs remarquables propriétés de transport électronique.

Le problème majeur rencontré lors de la réalisation de telles structures isolant-semiconductuer, consiste à réaliser le dépôt de l'isolant, de façon à obtenir un interface convenable isolant-semiconducteur. Cet interface doit permettre d'obtenir une structure dont les caractéristiques sont équivalentes aux systèmes connus $Si$-$SiO_2$. De la qualité de l'interface dépendent toutes le caractéristiques des composants électroniques réalisés.

Pour obtenir des couches isolantes sur les semiconducteurs plusieurs solutions sont connues. On sait, par exemple, former sur le semiconducteur une couche d'oxyde pour préparer des structures de formule $(A^{III}B^{V})O_4$. Cependant, si cette couche peut se former, il est extrêmement difficilement de la faire croître. Par ailleurs, il est possible de déposer par des techniques variées des des couches d'isolants à forte rigidité diélectrique (Ex : $SiO_2$, $Si_3N_4$, $Al_2O_3$, $P_3N_5$...). Par cette méthode on constate que la qualité de l'interface est médiocre.

Il a été montré précédemment (FR-A-2 454 184) qu'il était possible d'utiliser le procédé de sulfuration thermique pour former la couche diélectrique. L'utilisation d'un sulfure, dans le cas particulier d'un semiconducteur du type InP, étant motivée par le fait que les liaisons In-S- et P-S sont plus covalentes que les liaisons In-O et P-O. De plus, dans le composé $InPS_4$ stoechiométrique, les éléments In et P sont tous deux dans un environnement tétraédrique, ce qui constitue un facteur favorable au développement de la couche à partir de InP ; alors que dans $InPO_4$, l'atome d'indium est est dans un site octaédrique.

Cependant, ce procédé de sulfuration thermique implique une température de travail de 400°C, c'est-à-dire une température proche de la décomposition de InP. Cet inconvénient majeur conduit à un enrichissement de la couche en $In_2S_3$.

Il apparaît donc qu'aucun procédé connu dans la technique antérieure ne permet de maîtriser le dépôt de la couche isolante sur le substrat semiconducteur.

En vue de remédier aux difficultés sus-mentionnées, d'améliorer les qualités de l'interface et du diélectrique, la présente invention propose un procédé de dépôt d'une couche isolante de sulfure sur un substrat cristallin semiconducteur d'orientation particulière quelconque, dans lequel la sulfuration est assistée par plasma.

Pour ce faire, on soumet ledit substrat cristallin semi-conducteur à une décharge électro-luminescente dans une atmosphère gazeuse contenant au moins un dérivé du soufre.

Ce procédé de sulfuration assistée par plasma peut s'appliquer à la sulfuration de tous types de semiconducteurs, qu'ils soient binaires, ternaires ou quaternaires, pourvu que ces semiconducteurs aient une orientation déterminée. Les semiconducteurs binaires peuvent être du type $A^{II}B^{VI}$ ou du type $A^{III}B^{V}$. Mais le procédé selon la présente invention s'effectue de préférence sur les semiconducteurs $A^{III}B^{V}$ ou leurs alliages, et plus particulièrement sur $In^{III}P^{V}$ d'orientation cristalline 100.

La décharge électro-luminescente permettant la sulfuration du substrat est produite par un générateur dont la puissance est de préférence, comprise entre 15 et 90 W.

L'échantillon du semi-conducteur peut être placé dans le décharge luminescente, on parlera alors de plasma direct ; mais de préférence, cet échantillon est placé à l'extérieur de cette décharge et ce, notamment dans le cas de semi-conducteurs très sensibles au bombardement par les espèces ioniques crées par le plasma, on parlera alors de plasma indirect. Dans ce dernier cas de plasma indirect, la distance (d) entre le substrat et la décharge électro-luminescente est quelconque.

L'atmosphère gazeuse dans laquelle est créée ladite décharge électro-luminescente comporte au moins un dérivé gazeux du soufre qui est, de préférence, du sulfure d'hydrogène ($H_2S$). Le débit d'$H_2S$ ($d_{H2S}$) peut être quelconque. Cette atmosphère gazeuse peut aussi consister en un mélange de gaz comportant en plus de $H_2S$ d'autres gaz et, notamment des phosphines en particulier, $PH_3$ ou ses dérivés. Ceux-ci permettent notamment de maintenir une pression en phosphore.

Un des avantages principaux du procédé selon la présente invention est que la température du substrat (T) est inférieure à la température de décomposition du semiconducteur qui est de 350°C.

La pression de travail ($\pi$), selon l'invention, est de préférence compris entre une très basse pression et la pression atmosphérique.

2

Ainsi, la décharge électro-luminescente pourra s'effectuer avec une fréquence de générateur de plasma généralement comprise entre environ 30 kHz et 14 MHz.

La durée de sulfuration (t) nécessaire au procédé selon la présente invention est généralement comprise entre 5 min et 1 h 30.

Dans ces conditions, la sulfuration est effective dès 220°C (la température de sulfuration thermique était supérieure à 330°C).

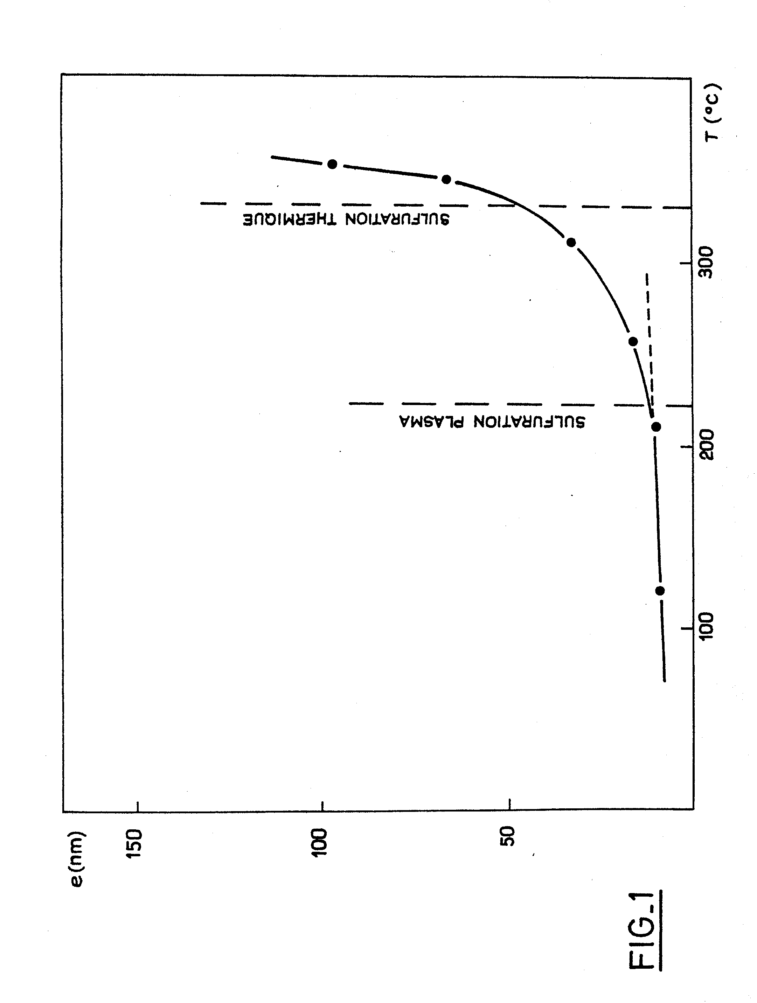

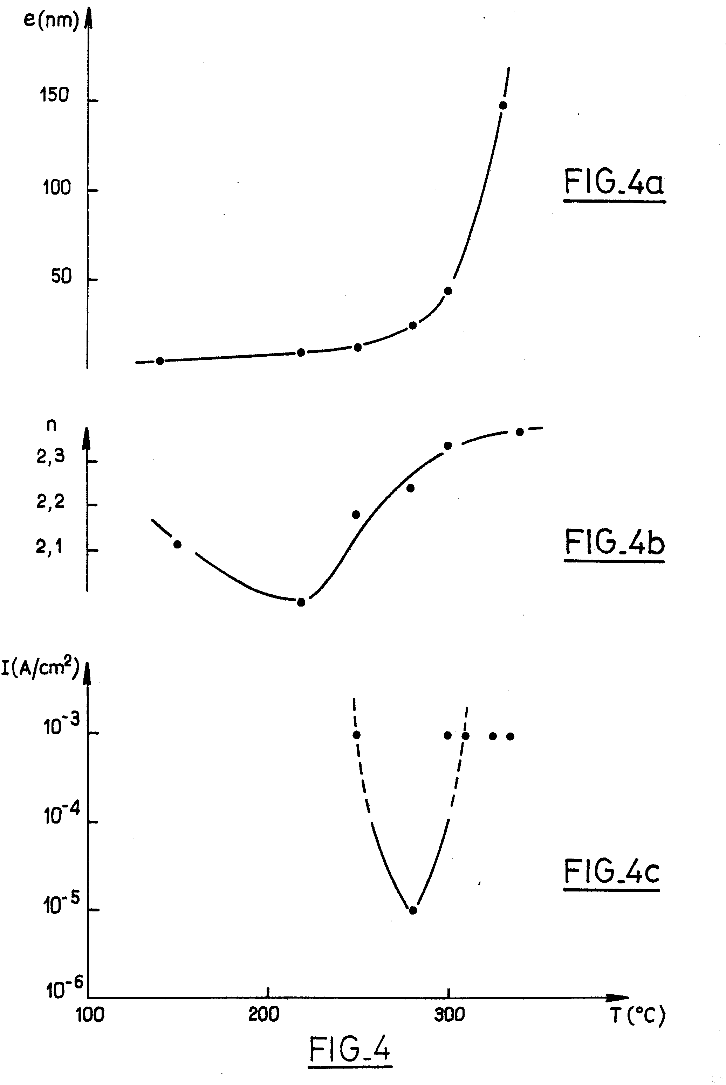

Les cinétiques de croissance des couches dépendent des paramètres ; tempérautre (T),temps (t),puissance du générateur (P), pression à l'intérieur du réacteur ($\pi$), débit des gaz réactifs (dgaz) et distance échantillon-plasma (d). Les courbes des figures 1 et 4a annexées montrent l'épaisseur (e) de la couche de sulfure déposée en fonction du temps pour différentes températures dans les deux cas : plasma direct et plasma indirect. Il apparaît que dans le cas du plasma indirect, pour une température supérieure à 280°C le type de croissance change d'allure pour atteindre une cinétique très rapide.

La sulfuration assistée par plasma est obtenue par réaction chimique entre le substrat et les espèces issues de la décharge électroluminescente dans le sulfure d'hydrogène ou dans les mélanges $H_2S + PH_3$.

Au cours de la formation de la couche de sulfure, on peut, selon la présente invention, activer sa croissance, soit par des moyens thermiques, soit par des moyens électriques. Dans ce dernier cas, l'échantillon peut être polarisé par rapport au potentiel de plasma.

Préalablement à la sulfuration assistée par le plasma, on effectue de préférence un balayage du réacteur par de l'azote suivi de la mise en atmosphère réactive du sulfure d'hydrogène du réacteur.

La vitesse de croissance des couches de sulfure ainsi obtenues varie entre 1 et 10 nm/min.

Enfin, le procédé selon la présente invention peut encore être amélioré, et ce, par dépôt ultérieur d'un isolant rigide sur la couche de sulfure formée. Différents isolants rigides peuvent être intéressants, et notamment $SiO_2$, $Si_3N_4$ ou $P_3N_5$. Ces isolants permettent en effet de former une couche de passivation pour éviter tout risque de dégradation ou d'oxydation du diélectrique.

La présente invention concerne aussi, bien évidemment, la structure obtenue par le procédé décrit ci-dessus, à savoir des dérivés sulfurés ou mélange de sulfures et/ou d'oxy-sulfures d'éléments semi-conducteurs d'orientation particulière.

Lesdits éléments étant essentiellement du type $A^{III}B^V$, les dérivés selon la présente invention répondent à la formule :
$(A^{III}_x B^V_Y)O_z S_w$, dans laquelle :
- A et B représentent respectivement des éléments des colonnes III et V de la classification périodique Mendeleïv,
- x, y, z et w sont quelconques et définissent de préférence une formule non stoechiométrique.

En effet, les conditions dans lesquelles on effectue la sulfuration, en particulier la faible température du substrat, permettent de préparer une structure tout-à-fait nouvelle, aussi bien au niveau de ses caractéristiques électriques, que de la composition de sa couche sulfurée.

En particulier, lorsque A représente l'indium et B représente le phosphore, ladite couche sulfurée est beaucoup plus riche en phosphore que ne l'était celle obtenue par un procédé de sulfuration thermique. En effet, la nouvelle structure InP obtenue diffère de la technique antérieure, essentiellement par l'absence de stoechiométrie de la couche isolante. Cette différence dans la composition chimique est apparue par analyse spectroscopique ; la valeur du rapport des

concentrations $\dfrac{[P]}{[In]}$ est, de préférence

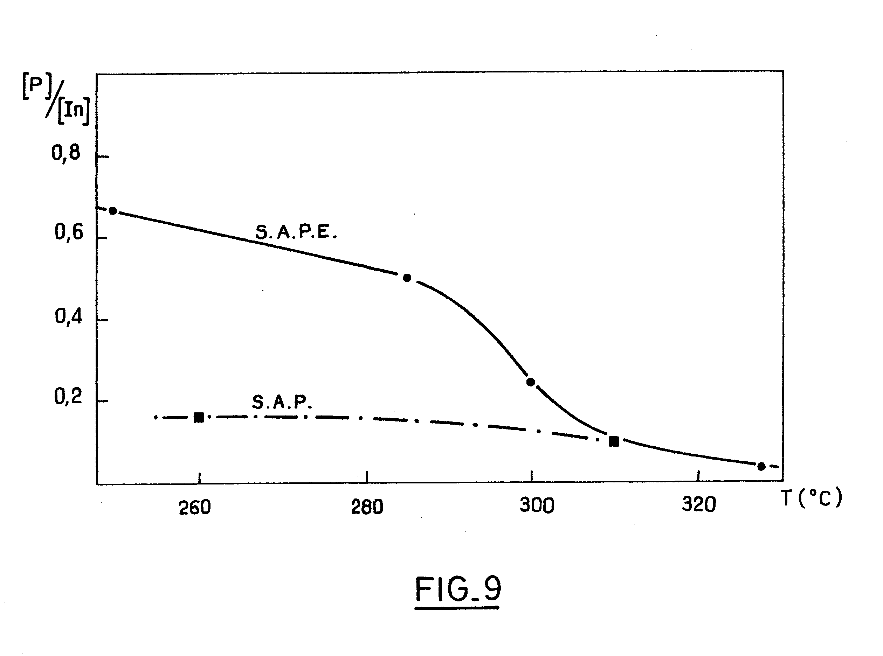

selon la présente invention, supérieur à environ 0,2. Ce rapport augmente notablement lorsque l'on passe de la technique plasma direct à la technique plasma indirect sans toutefois atteindre la valeur théorique 1 obtenue par le procédé de sulfuration thermique connu dans la technique antérieure (voir figure 9). Du point de vue des caractéristiques électriques, la qualité de l'interface de la structure obtenue est excellente. De plus, la valeur des courants de fuite est inversement proportion

nelle au rapport $\dfrac{[P]}{[In]}$ de la composition de la

couche. Une augmentation de ce rapport ne peut qu'aller vers une diminution des courants de fuite. Cependant pour diminuer encore des courants une seconds couche rapportée de diélectrique rigide peut être nécessaire.

Ainsi, la présente invention concerne les dérivés précédemment décrits dans lesquels la couche de sulfure est revêtue par un isolant à forte rigidité diélectrique tel que $SiO_2$, $Al_2O_3$, $Si_3N_4$ ou $P_3N_5$.

La présente invention concerne enfin l'appareillage nécessaire pour la préparation des dérivés tels que décrits ci-dessus.

En particulier, la sulfuration selon la présente invention, est réalisée dans un réacteur à plasma dont les parois peuvent être chaudes, cette chaleur assurant l'homogénéité de température du substrat semiconducteur à sulfurer. Mais de préférence, les parois du réacteur sont froides, l'élevation et la régulation de température dudit substrat étant alors permises par un porte-substrat chauffant.

En outre, le réacteur de sulfuration à plasma peut être relié par l'intermédiaire d'un sas à un second réacteur dans lequel on effectue le dépôt d'un isolant de rigidité diélectrique élevée sur la couche de sulfure.

La présente invention sera mieux comprise à la lecture des exemples suivants, à l'aide des figures 1 à 10.

Les figures 1 à 3 concernent le procédé de sulfuration assisté par plasma direct (SAP).

Les figures 4 à 8 concernent le procédé de sulfuration assisté par plasma indirect (SAPE).

Les figures 9 et 10 concernent des mesures comparatives entre les procédés SAP et SAPE.

La figure 1 représente l'évolution de l'épaisseur (e) de la couche de sulfure formée en fonction de la température (T) du substrat.

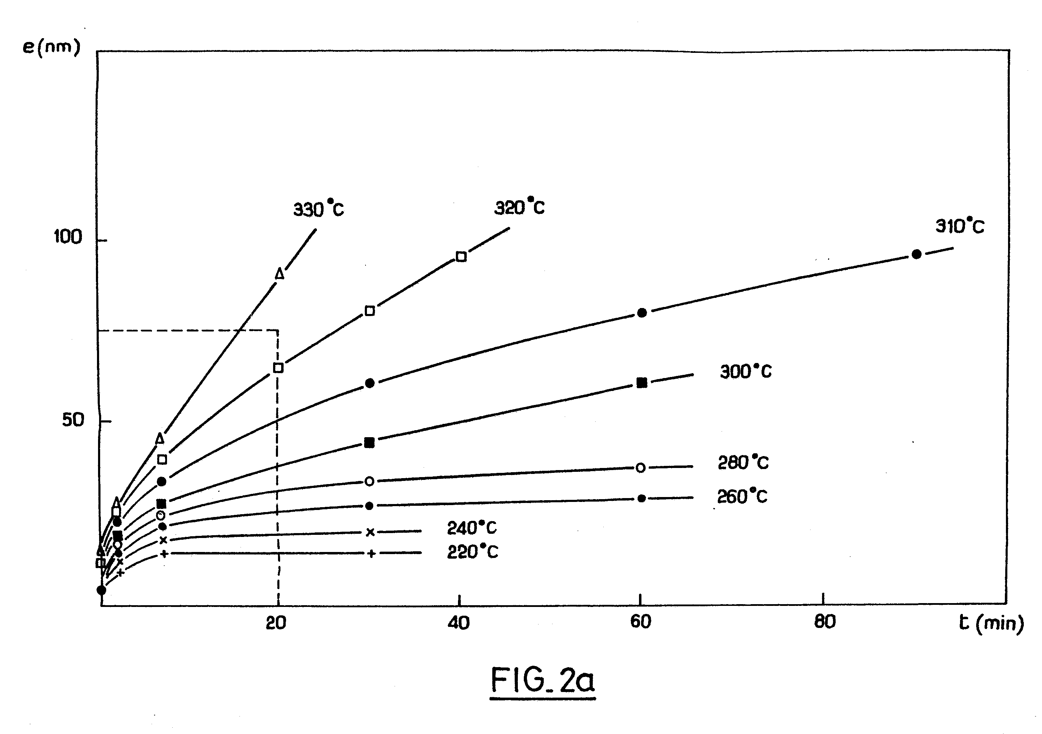

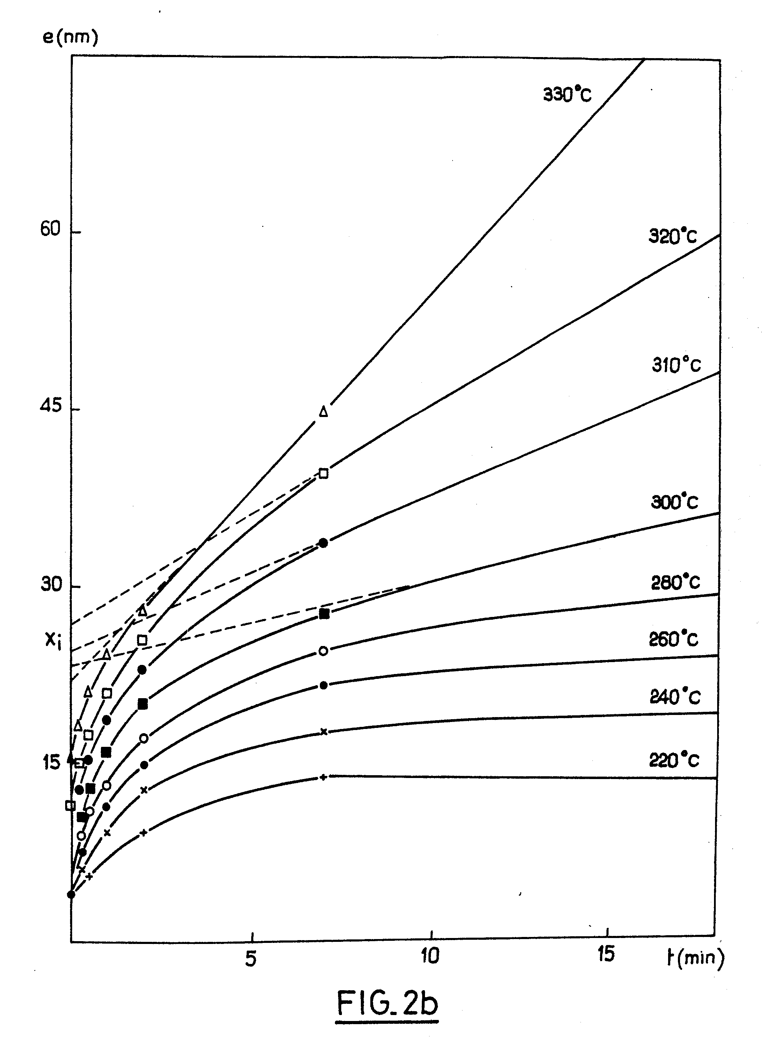

Les figures 2a et 2b représentent l'évolution de l'épaisseur (e) de la couche de sulfure formée en fonction du temps (t) d'application du plasma $H_2S$ pour différentes températures (T) du substrat.

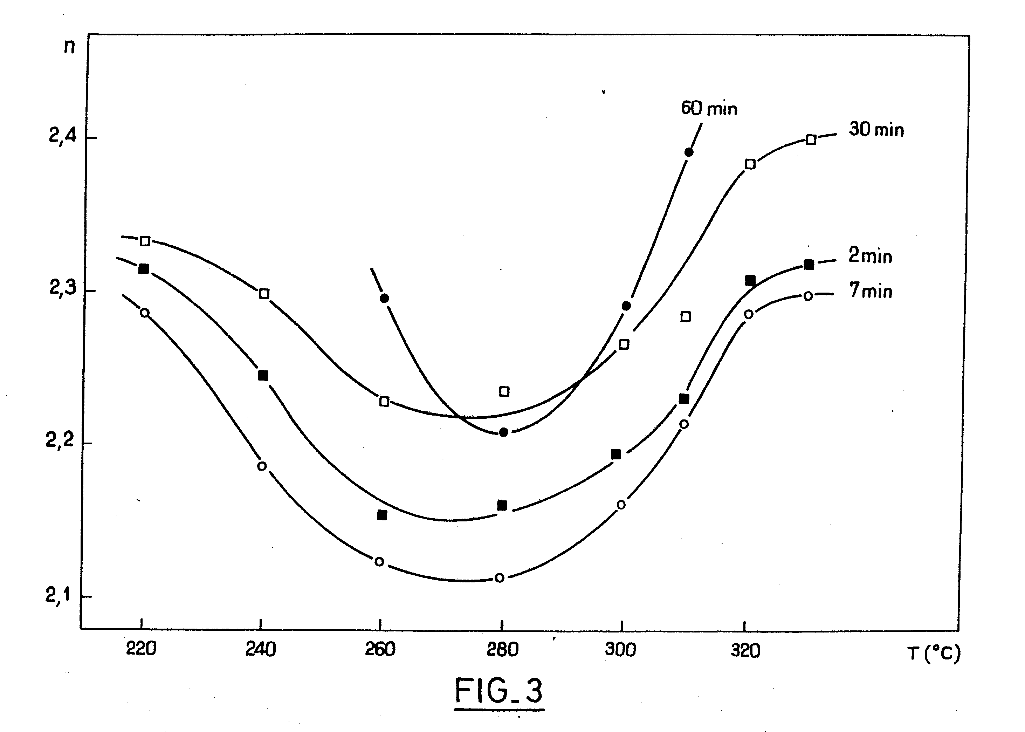

La figure 3 représente l'évolution de l'indice de réfraction (n) des couches de sulfure en fonction de la température (T) du substrat pour différents temps (t) de sulfuration.

La figure 4 représente l'influence de la température du substrat (T) sur :
● l'épaisseur (e) de la couche de sulfure formée (fig 4 a),
● l'indice de réfraction (n) (fig 4b),
● la valeur des courants de fuite I (fig 4c).
Dans les conditions suivantes :
P = 30 W
d = 1,3 cm
$\pi$ = 0,7 mb
$dH_2S$ = 1080 cm³/min
t = 26 min.

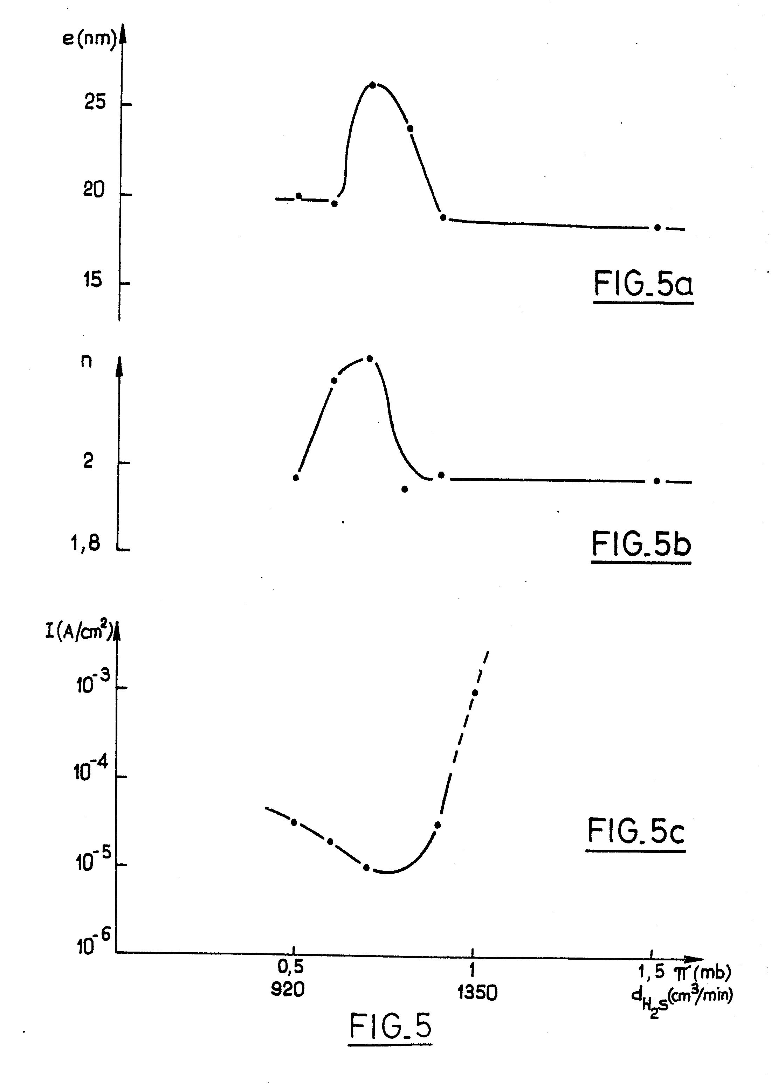

La figure 5 représente l'influence de la pression $\pi$ à débit variable sur "
● e (fig 5a)
● n (fig 5b)
● I (fig 5c)
Dans les conditions suivantes
P = 30 W
T = 280°C
d = 1,3 cm
t = 26 min.

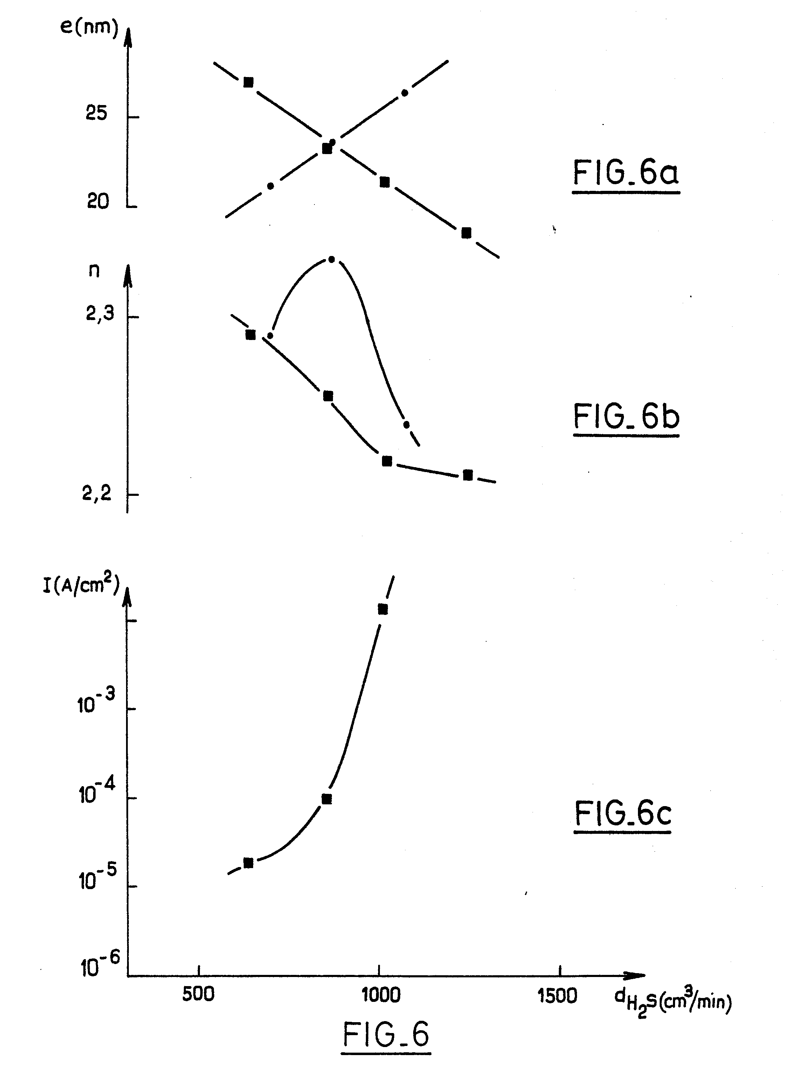

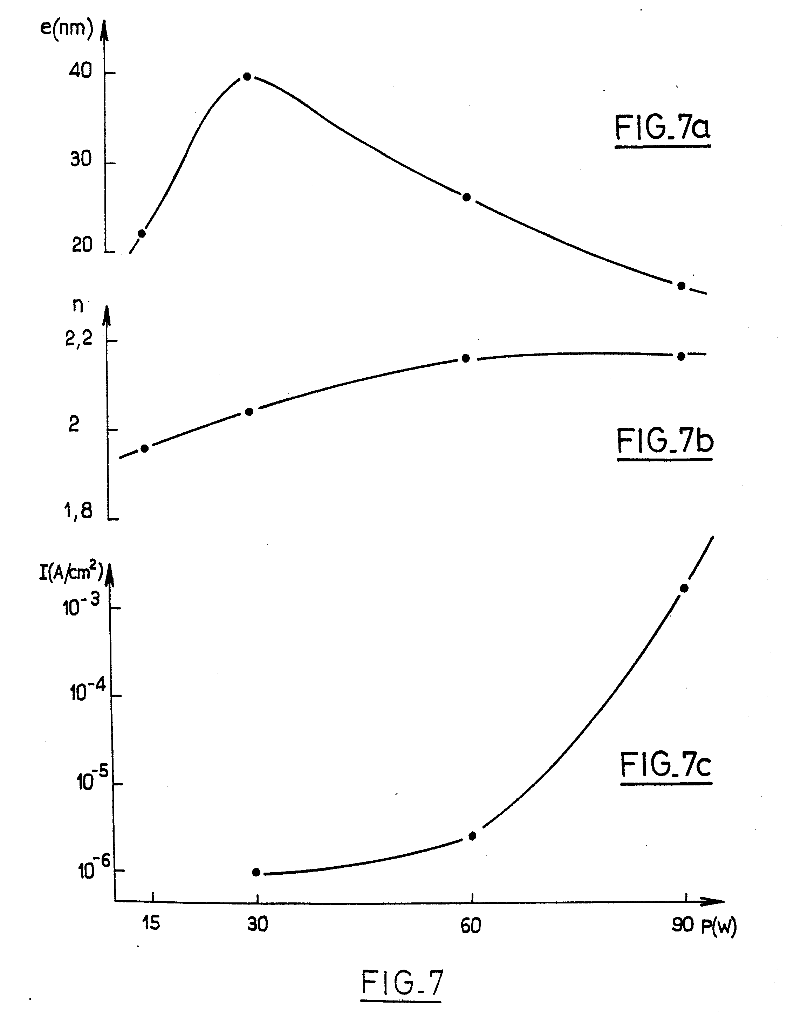

La figure 6 représente l'influence du débit en $H_2S$ à pression constante sur
● e (fig 6a)
● n (fig 6b)
● I (fig 6c)
dans les mêmes conditions que pour la figure 7.
La pression $\pi$ est égale à 1 mbar(■) ou à 0,7 mbar (●).

La figure 7 représente l'influence de la puissance délivrée par le générateur sur :
● e (7a)
● n (7b)
● I (7c).
Dans les conditions suivantes
T = 280°C
$\pi$ = 0,7 mbar
$dH_2S$ = 1080 cm³/min
d = 1,3 cm
t = 60 min.

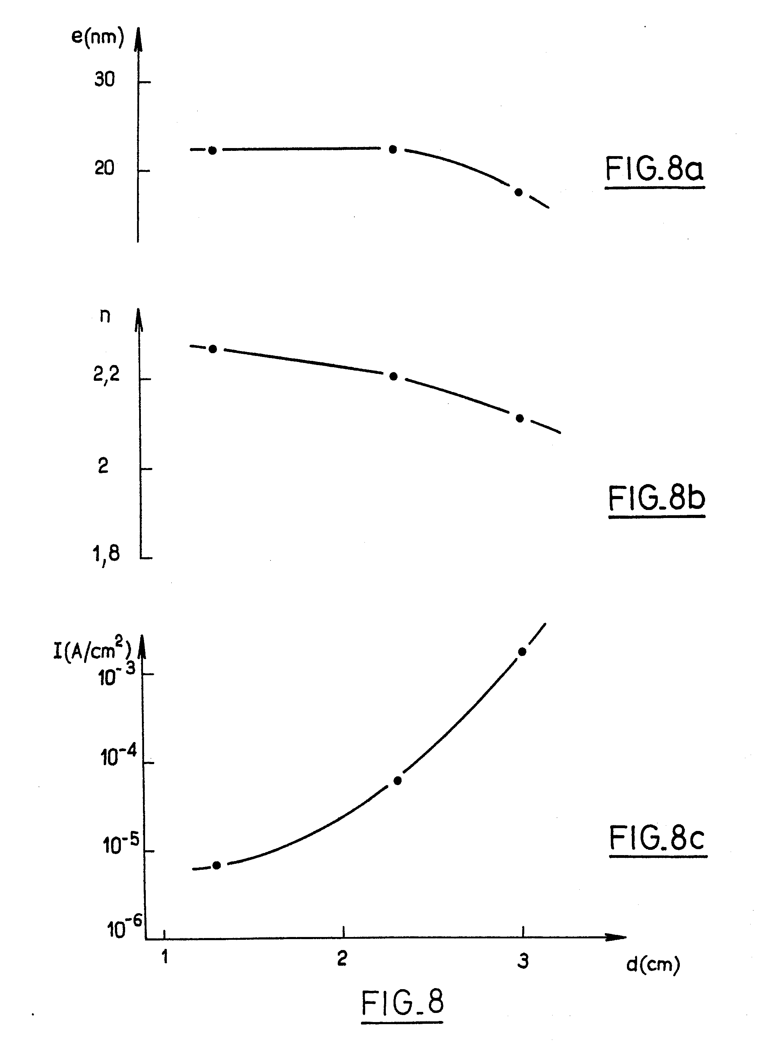

La figure 8 représente l'influence de la distance du substrat par rapport à la nacelle sur :
● e (fig 8 a )
● n (fig 8 b)
● I (fig 8 c)
dans les conditions suivantes
T = 290°C
$\pi$ = 0,7 mbar
$dH_2S$ = 1040 cm³/min
P = 30 W
t = 26 min

La figure 9 représente l'influence de la tem-

pérature du substrat sur le rapport $\dfrac{[P]}{[In]}$ , dans

les conditions suivantes :

P = 30 W
d = 3 cm
$\pi$ = 0,7 mbar
$dH_2S$ = 1080 $cm^3/min$

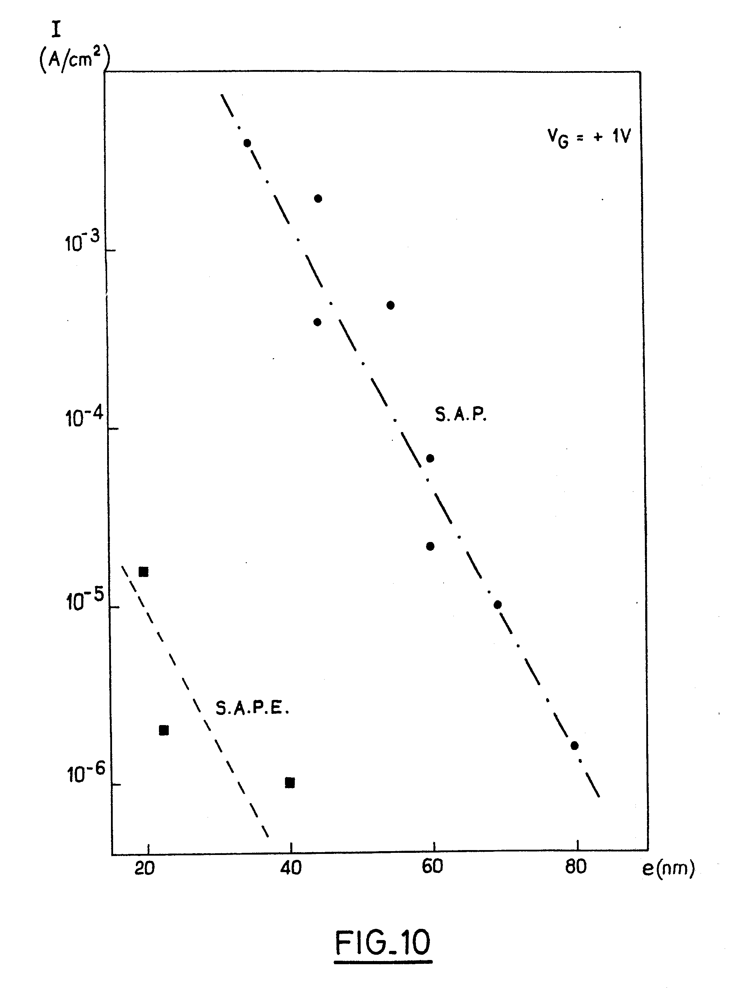

La figure 10 représente une comparaison des courants de fuite des couches SAP et SAPE en fonction de l'épaisseur des couches.

EXEMPLE 1 :

Etude de la cinétique de croissance des couches S.A.P.

Les épaisseurs des couches formées sont mesurées par ellipsométrie. Les paramètres de la décharge sont fixés aux valeurs suivantes :
- Puissance délivrée par le générateur HF : 90 W (P)
- débit en $H_2S$ : 1350 $cm^3/min$ ($dH_2S$
- pression dans la chambre : 1,1 mbar ($\pi$)

La figure 1 montre l'influence de la température du substrat sur la cinétique de croissance. La croissance débute dès T = 220°C. On notera qu'il fallait une température supérieure à T = 330°C pour que la croissance soit effective en sulfuration thermique.

Les 2a et 2b montrent que la cinétique de croissance peut prendre deux forme suivant que l'épaisseur est inférieure ou supérieure à une épaisseur critique $x_l$ = 25 + 2,5 nm (fig. 2b).

EXEMPLE 2 :

Caractérisation physichochimique des couches S.A.P.

● Topographie

Les micrographies obtenues par Microscopie Electronique à Balayage ont permis d'établir la topographie des surfaces de couches sulfurées obtenues pour différentes températures.

On observe pour une température critique T = 315°C un début de rugosité. En dessous de cette température la surface est "lisse" alors qu'au dessus de celle-ci on observe une surface "finement granulée". On notera toutefois que même dans ce dernier cas la rugosité des couches obtenues par sulfuration assistée plasma est nettement moindre que celles des couches obtenues par sulfuration thermique.

● Diffraction électronique

La Profondeur d'analyse par diffraction él6ctronique est de l'ordre de 10 nm.

On observe une structure polycristalline pour des températures inférieures à 280°C et une structure monocristalline pour des températures supérieures à 280°C.

● Indice de réfraction

Outre les mesures d'épaisseur, nous avons mesuré par ellipsométrie ($\pi$ = 632 nm sous une incidence de 70°C) l'évolution de l'indice de réfraction des couches S.A.P. en fonction de la température du substrat pour différents temps de sulfuration (fig. 3).

On observe quel que soit le temps de sulfuration, une évolution similaire de l'indice de réfraction (entre 2,1 et 2,4) en fonction de la température. Il passe par un minimum pour des températures comprises entre 260 et 280°C, puis augmente pour tendre à une valeur constante pour une température supérieure à 320°C.

EXEMPLE 3 :

Caractérisation électrique des couches S.A.P.

Les propriétés électriques de ces couches montrent que les courants de fuite sont parfois encore trop élevés.

On a attribué ces propriétés au défaut de phosphore dans ces couches, défaut résultant du bombardement des couches par les ions issus du plasma. Pour éviter ce bombardement, on s'est orienté vers la Sulfuration Assistée Plasma de InP avec le substrat placé à l'Extérieur de la décharge de $H_2S$ (S.A.P.E.).

EXEMPLE 4 :

# 0 265 314

Sulfuration Assitée Plasma de InP avec substrat placé à l'Extérieur du plasma (S.A.P.E.)

Le substrat d'InP est placé sur un support en verre, à la distance souhaitée de la nacelle où est créée la décharge électroluminescente dans $H_2S$.

On a étudié l'influence sur les caractéristiques des couches formées, des différents paramètres :
- température de substrat(T),
- pression dans le réacteur($\pi$),
- débit en $H_2S$($d_{H_2S}$),
- distance de l'échantillon par rapport à la nacelle(d)
- puissance délivrée par le générateur(P)

● Cinétique de croissance, indice de réfraction et courants de fuite

On présentera sur une même figure, l'influence de ces différents pramètres sur l'épaisseur (e) de la couche formée,son indice de réfraction (n) et la valeur des courants de fuite déterminée par les courbes I(V).

a) Influence de la température de substrat T (fig. 4)

On observe, comme pour la S.A.P. que la croissance débute pour une température T=220°C. On met en évidence un faible domaine de température centré à T=280°C pour lequel la rigidité diélectrique est acceptable ; $I \simeq 10^{-5}$ A/cm$^2$ pour une épaisseur de couche de 26,5 nm.

b) Influence de la pression à débit variable (fig.5)

On observe une cinétique de croissance avec un maximum pour une pression $\pi = 0,7$ mbar ($d_{H_2S} = 1080$ cm$^3$/min) correspondant à un maximum pour l'indice de réfraction et un minimum pour les courants de fuite (à épaisseur de couche constante).

c) Influence du débit en $H_2S$ a pression constante (fig 6)

Pour $\pi = 0,7$ mbar, la cinétique de croissance augmente avec le débit, alors que pour $\pi = 1$ mbar, elle diminue avec le débit. Pour cette pression $\pi = 1$ mbar, les courants de fuite sont d'autant plus faibles que le débit en $H_2S$ est faible.

d) Influence de la puissance délivré par le générateur (fig.7 ).

On observe, comme pour la pression à débit variable, une cinétique avec maximum pour une puissance de 30 W. Ce maximum correspond là aussi à\un minimum pour les courants de fuite (à épaisseur de couche constante).

e) Influence de la distance par rapport à la nacelle (fig. 8).

Au delà d'une distance 2,3 cm la cinétique de croissance diminue. On observe une faible influence de la distance, à épaisseur de couche constante, sur les courants de fuite.

● Interprétation

On retiendra de ces résultats expérimentaux :

1) La valeur des courants de fuite est inversement propor-

$$\text{tionnelle au rapport} \quad \frac{[P]}{[In]} \quad \text{de la composition des}$$

couches.

2) Au delà de certaines valeurs de la puissance plasma et du débit $H_2S$ les cinétiques de croissance diminuent. Il y correspond une augmentation des courants de fuite et

$$\text{une diminution du rapport} \quad \frac{[P]}{[In]}$$

Des débits en $H_2S$ et des puissances plasma plus grands entraînent des plasmas plus énergétiques qui débordent de l'espace interélectrode de la nacelle. Le substrat se retrouve ainsi plongé dans le plasma, subissant à nouveau un bombardement par les espèces ioniques dimiuant la cinétique de croissance et la valeur du rapport

$$\frac{[P]}{[In]}$$

3) Placé à une distance de 1,3 cm, pour une pression de 0,7 mbarle substrat et la couche qui se forment sont en dehors du plasma et ne subissent pas de dégradation. La cinétique de croissance augmente avec le débit en $H_2S$. Le phénomène inverse se produit pour une pression de 1 mbar.

Un compromis $\pi = 0,7$ mbar,$d_{H_2S} = 1080$ cm$^3$/min semble, à l'heure actuelle le meilleur pour avoir une cinétique de croissance et un rapport

$$\frac{[\ P\ ]}{[\ In\ ]}$$

optimum.

4) Dans les meilleures conditions de sulfuration S.A.P.E. réalisées à l'heure actuelle, on observe (figure 10) un gain de trois décades pour la valeur des courants de fuite caractéristiques de ces couches comparée aux couches obtenues en sulfuration S.A.P.

**Revendications**

1. Procédé de dépôt d'une couche isolante comportant du sulfure surun substrat cristallin semiconducteur d'orientation particulière, en particulier en vue de créer une structure MIS, caractérisé en ce que l'on soumet ledit substrat cristallin semiconducteur à une décharge électro-luminescente dans une atmosphère gazeuse contenant au moins un dérivé gazeux du soufre.

2. Procédé selon la revendication 1, caractérisé en ce que le substrat cristallin est un semiconductuer du type $A^{III}B^V$ ou son alliage.

3. Procédé selon la revendication 2, caractérisé en ce que le substrat cristallin est $In^{III}P^V$ d'orientation cristalline 100.

4. Procédé selon l'une quelconque des revendications 1 à 3, caractérisé en ce que la décharge électro-luminescente est produite par un générateur de plasma.

5. Procédé selon l'une quelconque des revendications 1 à 4, caractérisé en ce que la décharge électro-luminescente est produite par un générateur de plasma dont la fréquence est comprise entre 30 kHz et 14 MHz.

6. Procédé selon l'une quelconque des revendications 1 à 5, caractérisé en ce que le substrat semiconducteur est placé à l'intérieur de la décharge électro-luminescente.

7. Procédé selon l'une quelconque des revendications 1 à 5, caractérisé en ce que le substrat semiconducteur est placé à l'extérieur de la décharge électro-luminescente.

8. Procédé selon l'une quelconque des revendications 1 à 7, caractérisé en ce que l'atmosphère gazeuse comporte du sulfure d'hydrogène $H_2S$, éventuellement additionné de phosphines, en particulier $PH_3$.

9. Procédé selon l'une quelconque des revendications 1 à 8, caractérisé en ce qu'il s'effectue à une température du substrat semiconducteur inférieure à 350°C.

10. Procédé selon l'une quelconque des revendications 1 à 9, caractérisé en ce que la durée de sulfuration est comprise entre 5 min et 1 h 30.

11. Procédé selon l'une quelconque des revendications 1 à 10, caractérisé en ce qu'on active la croissance de la couche isolante.

12. Procédé selon la revendication 11, caractérisé en ce que l'activation est thermique.

13. Procédé selon la revendication 11, caractérisé en ce que l'activation est électrique.

14. Procédé selon l'une quelconque des revendications 1 à 13, caractérisé en ce que la sulfuration par plasma est précédée d'un balayage du réacteur par de l'azote, suivie de la mise en atmosphère réactive du réacteur par du sulfure d'hydrogène.

15. Procédé selon l'une quelconque des revendications 1 à 14, caractérisé en ce qu'on recouvre le sulfure par une couche de passivation comportant un isolant à forte rigidité diélectrique.

16. Dérivés sulfurés ou mélange de sulfures et/ou d'oxy-sulfures d'éléments semiconducteurs d'orientation particulière obtenus selon l'une quelconque des revendications 1 à 15.

17. Dérivés selon la revendication 16, caractérisés en ce qu'ils répondent à la formule
$(A^{III}{}_xB^V{}_y)\,O_zS_w$
dans laquelle :
- A et B représentent respectivement des éléments des colonnes III et V de la classification périodique de Mendeleïv,
- x, y, z et w sont quelconques et définissent de préférence une formule non stoechiométrique.

18. Dérivés selon la revendication 15 ou 17, caractérisés en ce qu'ils répondent à la formule :
$(In_x{}^{III}P^V{}_y)\,O_zS_w$
dans laquelle x, y, z et w sont quelconques et définissent de préférence une formule non stoechiométrique.

19. Dérivés selon la revendication 18, carac-

térisés en ce que le rapport des concentrations $\dfrac{[P]}{[In]}$

est supérieur à environ 0,2.

20. Dérivés selon l'une quelconque des revendications 16 à 19, caractérisés en ce que la couche de sulfure est revêtue par un isolant à forte rigidité diélectrique.

21. Dérivés selon la revendication 20, caractérisés en ce que l'isolant rigide est choisi parmi $SiO_2$, $Si_3N_4$, $Al_2O_3$ et $P_3N_5$.

22. Appareillage pour la mise en oeuvre du procédé selon l'une quelconque des revendications 1 à 15, caractérisé en ce qu'il comporte un réacteur à plasma dans lequel on effectue la sulfuration.

23. Appareillage selon la revendication 22, caractérisé en ce qu le réacteur à plasma est à parois chaudes.

24. Appareillage selon la revendication 22, caractérisé en ce que le réacteur à plasma est à parois froides.

25. Appareillage selon la revendication 24, caractérisé en ce que la température du substrat cristallin semiconducteur est réglée par l'intermédiaire d'un porte-substrat chauffant.

26. Appareillage selon l'une quelconque des revendications 22 à 25, caractérisé en ce que le réacteur de sulfuration est relié par l'intermédiaire d'un sas à un second réacteur dans lequel on effectue le dépôt d'un isolant de rigidité diélectrique élevée sur la couche de sulfure.

0265314

FIG_1

0265314

FIG.2a

0265314

FIG. 2b

0265314

FIG_3

0265314

FIG.4a

FIG.4b

FIG.4c

FIG.4

0265314

FIG.5a

FIG.5b

FIG.5c

FIG.5

0265314

FIG.6a

FIG.6b

FIG.6c

FIG.6

0265314

FIG.7a

FIG.7b

FIG.7c

FIG.7

0265314

FIG.8a

FIG.8b

FIG.8c

FIG.8

FIG_9

FIG. 10

Office européen
des brevets

# RAPPORT DE RECHERCHE EUROPEENNE

Numero de la demande

EP 87 40 2214

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-2 046 994 (D. CHEMLA et al.) <br> * En entier * <br><br> --- | 1-3,8, 11,12, 16 | H 01 L 21/314 <br> H 01 L 29/62 <br> H 01 L 29/40 |
| A | PATENT ABSTRACTS OF JAPAN, vol. 9, no. 96 (C-278)[1819], 25 avril 1985, page 67 C 278; & JP-A-59 226 173 (HITACHI SEISAKUSHO K.K.) 19-12-1984 <br> * Résumé * <br><br> --- | 1,4 | |
| A | THIN SOLID FILMS, vol. 131, no. 1/2, septembre 1985, pages 139-148, Elsevier Sequoia, Lausanne, CH; B. DESCOUTS et al.: "Thermal sulphidation on InP" <br> * En entier * <br><br> --- | 1,16-18 | |
| A | PATENT ABSTRACTS OF JAPAN, vol. 7, no. 162 (E-187)[1307], 15 juillet 1983, page 12 E 187; & JP-A-58 68 936 (NIPPON DENSHIN DENWA KOSHA) 25-04-1983 <br> * Résumé * <br><br> --- | 1-3,16 | DOMAINES TECHNIQUES RECHERCHES (Int. Cl.4) |
| A | EP-A-0 166 120 (INTERNATIONAL BUSINESS MACHINES CORP.) <br><br> ----- | | H 01 L <br> C 23 C |

Le présent rapport a été établi pour toutes les revendications

| Lieu de la recherche | Date d'achèvement de la recherche | Examinateur |
|---|---|---|
| LA HAYE | 08-01-1988 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................................
& : membre de la même famille, document correspondant

EPO FORM 1503 03.82 (P0402)